# FASCICULE DE BREVET EUROPEEN

(11) **EP 3 076 770 B1**
(45) Date de publication et mention de la délivrance du brevet: **15.02.2023**
(21) Numéro de dépôt: 15193592.1
(22) Date de dépôt: 09.11.2015
(51) Int. Cl.: H05K 1/14, H05K 1/02, H05K 1/18, H01R 12/71

(54) **CONNECTEUR ELECTRIQUE**
ELEKTRISCHER ANSCHLUSS
ELECTRICAL CONNECTOR

(30) Priorité: 03.04.2015 FR 1552910
(43) Date de publication de la demande: 05.10.2016
(73) Titulaire: STMicroelectronics (Tours) SAS, 37100 Tours (FR)
(72) Inventeur: EDET, Arnaud, 37000 TOURS (FR); NOPPER, Christian, 37510 SAVONNIERES (FR)
(74) Mandataire: Cabinet Beaumont

(56) Documents cités:
- US-A- 3 998 512
- US-A- 5 626 483
- US-A- 6 132 224
- US-A1- 2003 081 387
- US-A1- 2005 184 381
- US-A1- 2006 281 361
- US-A1- 2009 163 045

## Description

### Domaine

La présente demande concerne le domaine des connecteurs électriques utilisés dans des dispositifs électroniques, notamment dans des dispositifs électroniques mobiles tels que des ordinateurs portables, des tablettes, ou des téléphones portables.

### Exposé de l'art antérieur

De nombreux dispositifs électroniques, notamment des dispositifs électroniques mobiles, comprennent une ou plusieurs cartes de circuit imprimé et des interfaces utilisateur telles que des claviers, des écrans, des microphones ou des caméras. Pour connecter électriquement les cartes et les interfaces utilisateur entre elles, on utilise des connecteurs électriques généralement associés à des rubans de connexion flexibles sur lesquels sont formées des pistes conductrices. Chaque connecteur comporte un premier élément monté sur une carte de circuit imprimé ou sur une interface utilisateur, et un élément complémentaire lié à un ruban de connexion. Des composants sont couramment montés sur la carte de circuit imprimé ou l'interface utilisateur, autour du premier élément de connecteur, pour associer certaines fonctions au connecteur. Par exemple, dans le cas d'un connecteur utilisé dans un téléphone portable, ces composants peuvent être des filtres de mode commun.

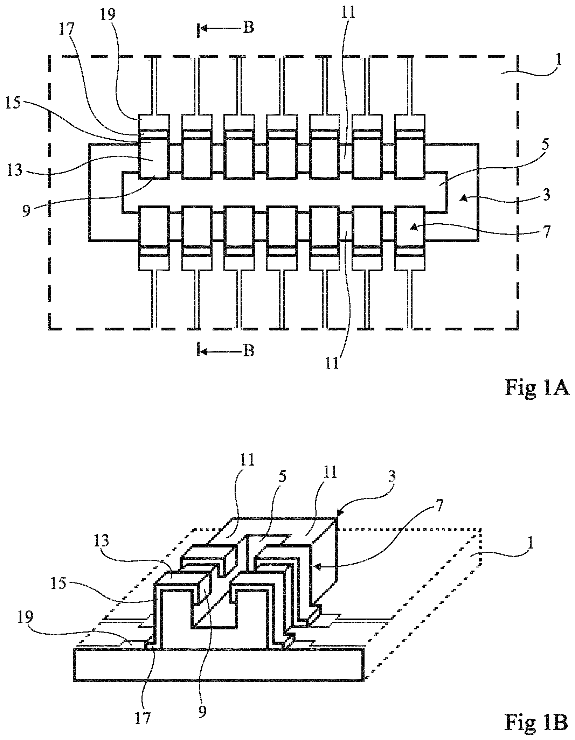

La figure 1A est une vue de dessus d'un exemple d'un élément de connecteur électrique à lames. La figure 1B est une vue en perspective et en coupe selon le plan B-B de la figure 1A. Dans ces figures, l'élément de connecteur est monté sur la face supérieure d'une carte de circuit imprimé 1.

L'élément de connecteur comprend un cadre rectangulaire électriquement isolant 3 fermé du côté de la carte de circuit imprimé 1 et délimitant une cavité allongée 5. Des lames métalliques 7 régulièrement espacées et parallèles entre elles servent de contacts. Chaque lame 7 comprend successivement une portion 9 disposée sur la face interne d'un grand côté 11 du cadre 3, une portion 13 disposée sur la tranche supérieure de ce grand côté 11, et une portion 15 disposée sur la face externe de ce grand côté 11, la portion 15 se prolongeant en une portion 17 qui repose sur la carte de circuit imprimé 1 et qui est soudée à un plot 19 de la carte 1. Au moins les portions 9 et 15 de chaque lame 7 forment des zones de contact de l'élément de connecteur.

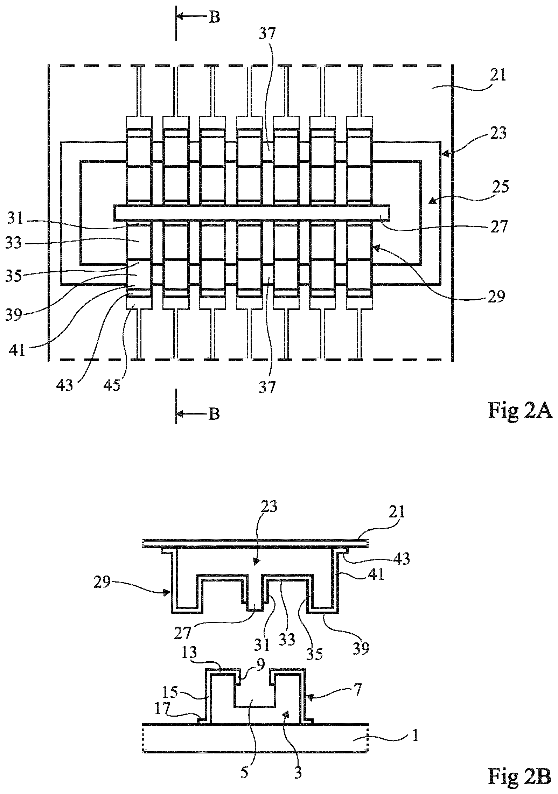

Les figures 2A et 2B représentent un exemple d'un élément de connecteur électrique à lames, complémentaire de celui des figures 1A et 1B. Les figures 2A et 2B sont respectivement une vue de dessous et une vue en coupe de l'élément de connecteur complémentaire, la figure 2B étant une vue en coupe selon le plan B-B de la figure 2A. Dans ces figures, l'élément de connecteur complémentaire est monté sur la face inférieure d'un ruban de connexion 21. En figure 2B, l'élément de connecteur complémentaire est représenté en regard de l'élément de connecteur des figures 1A et 1B.

L'élément de connecteur complémentaire comprend un bloc électriquement isolant 23 constitué d'un cadre rectangulaire 25 fermé du côté du ruban 21, et d'une portion saillante allongée 27, entourée par le cadre 25. Des lames métalliques 29 régulièrement espacées et parallèles entres elles servent de contacts. Chaque lame 29 comprend successivement une portion 31 disposée sur une face latérale longitudinale de la portion saillante 27, une portion 33 disposée sur le bloc 23, une portion 35 disposée sur la face interne d'un grand côté 37 du cadre 25, une portion 39 disposée sur la tranche de ce grand côté 31, et une portion 41 disposée sur la face externe de ce grand côté 31, la portion 41 se prolongeant en une portion 43 qui repose sur le ruban de connexion 21 et qui est soudée à un plot 45 du ruban 21. Au moins les portions 31 et 35 de chaque lame 29 forment des zones de contact du connecteur complémentaire.

Un premier élément d'un connecteur électrique à lames comprend le même nombre de lames métalliques que l'élément complémentaire, les positions des lames étant telles qu'à chaque lame du premier élément du connecteur correspond une lame de l'élément complémentaire. Les dimensions de chacun des deux éléments du connecteur sont telles que la cavité du premier élément du connecteur puisse accueillir la portion saillante de l'élément complémentaire, et que les zones de contact du premier élément du connecteur soient alors en contact avec celles de l'élément complémentaire. On a décrit ici un exemple de connecteur à lames dans lequel chaque lame du premier élément de connecteur est embrassée par chaque lame de l'élément de connecteur complémentaire. Il existe aussi des connecteurs à lames dans lesquels l'élément de connecteur complémentaire comprend simplement une portion saillante venant s'insérer dans la cavité du premier élément de connecteur.

En pratique, les éléments d'un connecteur à lames sont fabriqués à partir d'un bloc ou d'un cadre électriquement isolant, par exemple en plastique thermoformé, sur lequel on reporte des lames métalliques. L'espace séparant deux lames adjacentes et la largeur des lames sont alors imposés par des considérations mécaniques. Couramment, les lames métalliques ont une largeur d'au moins 100 pm, et deux lames adjacentes sont séparées d'au moins 150 µm. Ainsi, du fait qu'il est difficile de réduire les dimensions des lames et l'espace séparant deux lames adjacentes, il est difficile de réduire les dimensions d'un élément de connecteur à lames. En outre, chaque lame de contact est nécessairement connectée à un plot déterminé du support sur lequel est monté l'élément de connecteur.

Des éléments de connecteurs électriques ont été proposés. Le brevet US n°5626483 décrit un exemple de connecteur électrique ayant des contacts formés par placage métallique. Le brevet US n°3998512 décrit un exemple de connecteur électrique. La demande de brevet US n°2009/0163045 décrit exemple de châssis isolant à placage métallique et muni d'un connecteur. La demande de brevet US n°2005/0184381 décrit un exemple de dispositif de connexion de cartes électroniques.

Il serait souhaitable de disposer d'un élément de connecteur électrique ayant notamment pour avantage de pallier au moins certains des inconvénients d'un élément de connecteur électrique à lames.

### Résumé

Ainsi, la présente invention prévoit un élément de connecteur électrique selon la revendication 1.

Selon un mode de réalisation, le cadre comprend deux entretoises séparant les grands côtés du cadre.

Selon un mode de réalisation, chaque entretoise est une portion de carte de circuit imprimé.

Selon un mode de réalisation, la face externe de chaque carte comprend des premières zones de connexion, la face interne de chaque carte comprend des deuxièmes zones de connexion, chaque première zone de connexion étant en regard d'une deuxième zone de connexion et étant connectée à la deuxième zone de connexion en regard par un premier via traversant.

Selon un mode de réalisation, les premiers vias traversants de chaque carte sont ouverts au niveau de la tranche de la carte destinée à être en contact avec le support.

Selon un mode de réalisation, la face interne de chaque carte comprend des premières zones de contact, la face externe de la carte comprend des deuxièmes zones de contact, chaque première zone de contact étant en regard d'une deuxième zone de contact et étant connectée à la deuxième zone de contact en regard par un deuxième via traversant.

Selon un mode de réalisation, le cadre est rectangulaire.

Selon un mode de réalisation, une plaque ferme le côté du cadre destiné à être en contact avec un support.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B, décrites précédemment, représentent un exemple d'un élément de connecteur électrique à lames ;
les figures 2A et 2B, décrites précédemment, représentent un exemple d'un élément de connecteur électrique à lames complémentaire de celui des figures 1A et 1B ;
les figures 3A et 3B sont des vues schématiques, respectivement de dessus et en perspective, d'un mode de réalisation d'un élément de connecteur électrique ; et
la figure 4 est une vue en coupe et en perspective d'une variante de réalisation de l'élément de connecteur électrique des figures 3A et 3B.

### Description détaillée

De mêmes éléments ont été désignés par de mêmes références dans les différentes figures et, de plus, les diverses figures ne sont pas tracées à l'échelle.

Dans la description qui suit, des termes tels que "supérieur", "inférieur" se réfèrent à l'orientation des éléments concernés dans les figures correspondantes.

On propose ici de réaliser un élément de connecteur électrique à partir de cartes de circuit imprimé multicouches.

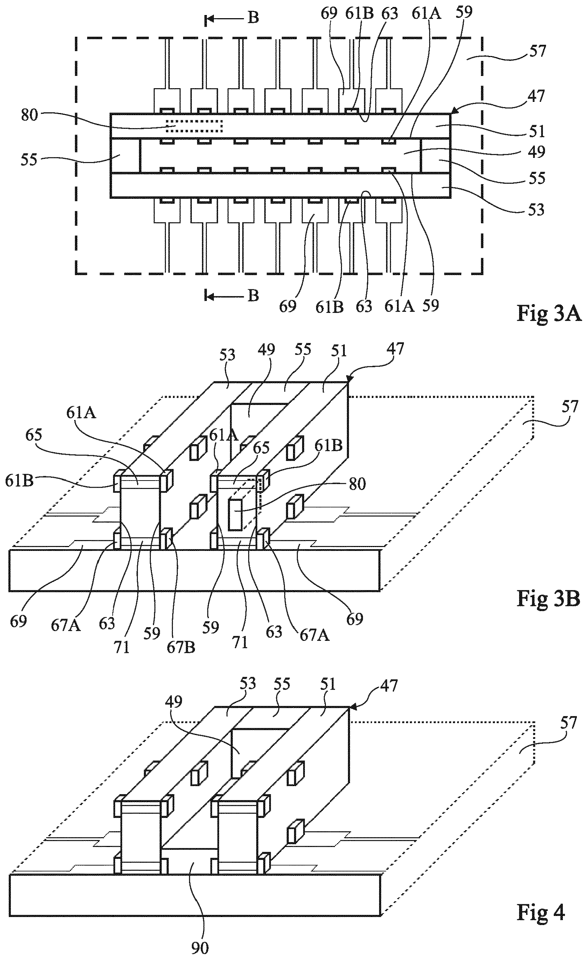

Les figures 3A et 3B sont des vues schématiques, respectivement de dessus et en perspective, d'un mode de réalisation d'un élément de connecteur, la figure 3B étant une vue en coupe selon le plan B-B de la figure 3A. L'élément de connecteur des figures 3A et 3B est interchangeable avec l'élément de connecteur des figures 1A et 1B, et est compatible avec l'élément de connecteur complémentaire des figures 2A et 2B.

Le connecteur comprend un cadre rectangulaire 47 délimitant une cavité allongée 49. Chaque grand côté du cadre 47 est constitué d'une carte de circuit imprimé 51, 53 à au moins trois niveaux de couches métalliques. Chaque petit côté du cadre 47 est constitué d'une entretoise 55, par exemple une portion de plaque isolante ou de carte de circuit imprimé, entre les cartes 51 et 53. La tranche inférieure de chaque carte 51, 53, et de chaque entretoise 55 du cadre 47 repose sur la face supérieure d'une carte de circuit imprimé 57 sur laquelle est monté l'élément de connecteur.

La face interne 59 de chaque carte de circuit imprimé 51, 53 comprend des zones de contact supérieures 61A disposées du côté de la partie supérieure de cette face 59. La face externe 63 de chaque carte 51, 53 comprend une zone de contact supérieure 61B en regard de chaque zone de contact supérieure 61A, deux zones 61A et 61B en regard étant connectées par un via traversant 65. Les zones de contact 61A et 61B sont destinées à être en contact avec les zones de contact de l'élément de connecteur complémentaire.

La face externe 63 de chaque carte de circuit imprimé 51, 53 comprend des zones de contact inférieures 67A disposées du côté de la partie inférieure de cette face 63, en contact avec la carte de circuit imprimé 57. Dans cet exemple, les zones de contact inférieures 67A ont un bord au même niveau que les tranches inférieures des cartes 51 et 53 et sont soudées à des plots 69 de la carte 57. La face interne 59 de chaque carte 51, 53 peut également comprendre une zone de contact inférieure 67B en regard de chaque zone de contact inférieure 67A, deux zones de contact inférieures 67A et 67B en regard étant connectées par un via traversant 71. De préférence, et contrairement à ce qui est représenté, les vias 71 sont ouverts sur toute leur longueur, au niveau des tranches inférieures des cartes 51 et 53, pour être soudés à des plots 69 de la carte de circuit imprimé 57. Dans ce cas, la surface de la carte 57 peut être réduite.

Les zones de contact inférieures 67A et 67B d'une carte 51, 53 sont connectées aux zones de contact supérieures 61A et 61B par des chemins conducteurs non représentés formés dans cette carte 51, 53. Dans un mode de réalisation, les entretoises 55 sont des portions de carte de circuit imprimé comprenant des chemins conducteurs qui permettent de connecter des zones de contact 61A, 61B, 67A et 67B de la carte de circuit imprimé 51 à des zones de contact de la carte de circuit imprimé 53.

L'élément de connecteur des figures 3A et 3B peut avoir des dimensions similaires à celles de l'élément de connecteur à lames des figures 1A et 1B, et être interchangeable avec celuici. L'élément de connecteur des figures 3A et 3B aura par exemple les dimensions suivantes :
- largeur des zones de contact supérieures 61A et 61B : 200 µm ;
- écart entre deux zones de contact 61A ou 61B : 150 µm ;
- épaisseur des cartes de circuit imprimé 51, 53 : 0,25±0,1 mm ;
- épaisseur des entretoises 55 entre les cartes 51 et 53 : 0,5±0,1 mm ; et
- hauteur des cartes 51, 53, et des entretoises 55 : 1,3±0,1 mm.

Les dimensions des zones de contact supérieures 61A et 61B, des cartes 51 et 53, et des entretoises 55 indiquées ci-dessus sont compatibles avec les procédés de fabrication existants de cartes de circuit imprimé.

On a décrit en relation avec les figures 3A et 3B un élément de connecteur interchangeable avec l'élément de connecteur à lames des figures 1A et 1B. On pourra aussi tirer profit de l'utilisation de cartes de circuit imprimé pour réaliser un élément de connecteur miniaturisé. En effet, les techniques associées à l'utilisation de cartes de circuit imprimé permettent de réaliser des zones de contact plus petites et plus serrées que les techniques associées à l'utilisation de lames métalliques. A titre d'exemple, chaque zone de contact 61A, 61B, 67A et 67B peut être un plot carré de 100 à 200 um de côté, par exemple 150 um, et l'espace séparant deux zones de contact 61A, 61B, 67A ou 67B adjacentes peut être compris entre 50 et 150 µm, par exemple 100 µm.

Dans le cas où l'élément de connecteur des figures 3A et 3B est miniaturisé, l'élément complémentaire peut alors également être réalisé à partir de cartes de circuit imprimé.

Comme cela est représenté en figures 3A et 3B, un avantage de l'élément de connecteur décrit en relation avec ces figures est que une ou plusieurs puces de circuit intégré 80 sont disposées dans l'une et/ou l'autre des cartes 51 et 53, les bornes des puces 80 étant connectées à des zones de contact 61A, 61B, 67A et 67B par des chemins conducteurs des cartes 51, 53. Ces puces 80 permettent d'associer des fonctions telles que des filtres ou des protections contre les surtensions au connecteur. Ainsi, il n'est plus utile de monter des composants sur la carte de circuit imprimé 57 autour de l'élément de connecteur pour lui associer ces fonctions. Il en résulte que les dimensions de la carte de circuit imprimé 57 peuvent être réduites ce qui est particulièrement intéressant dans le cas où cette carte 57 fait partie d'un dispositif électronique mobile.

La figure 4 est une vue en coupe et en perspective schématique représentant une variante de réalisation de l'élément de connecteur électrique des figures 3A et 3B, la portion de l'élément de connecteur représentée en figure 4 correspondant à celle représentée en figure 3B. Dans cette variante, le cadre 47 de l'élément de connecteur est fermé du côté de la carte de circuit imprimé 57 par une plaque 90 ce qui permet d'augmenter la résistance mécanique du cadre 47, et donc de l'élément de connecteur.

La plaque 90 est par exemple une portion d'une plaque d'un matériau isolant. La plaque 90 peut également être une portion d'une carte de circuit imprimé, et, dans le cas où les entretoises 55 sont également des portions de carte de circuit imprimé, les entretoises 55 et la plaque 90 peuvent être des portions d'une même carte.

Des modes de réalisation particuliers ont été décrits en relation avec les figures 3A, 3B et 4. Diverses variantes et modifications apparaîtront à l'homme de l'art. En particulier, les éléments de connecteur décrits précédemment pourront être montés sur un ruban de connexion, une interface utilisateur, et plus généralement sur n'importe quel support comprenant des pistes métalliques.

Les petits côtés du cadre des éléments de connecteur décrits précédemment définissent avec les grands côtés un cadre rectangulaire. Ces petits côtés pourront être obliques ou arrondis.

L'homme de métier pourra adapter la forme, les dimensions et la disposition des zones de contact des cartes de circuit imprimé.

D'autres fonctions que celles indiquées précédemment pourront être associées au connecteur grâce aux puces de circuit intégré disposées dans les cartes de circuit imprimé d'un des éléments du connecteur, par exemple des amplificateurs et des dispositifs de synchronisation.

Divers modes de réalisation avec diverses variantes ont été décrits ci-dessus. On notera que l'homme de l'art pourra combiner divers éléments de ces divers modes de réalisation et variantes.

## Revendications

1. Elément de connecteur électrique du type comprenant un cadre (47) délimitant une cavité ouverte allongée (49), ayant deux grands côtés parallèles munis de zones de contact (61A, 61B) aptes à coopérer avec des zones de contact d'un élément de connecteur électrique complémentaire, et étant destiné à être monté sur un support (57) muni de plots conducteurs (69),
**caractérisé en ce que** :
chaque grand côté est constitué d'une carte de circuit imprimé multicouches (51, 53) comprenant au moins trois niveaux de couches métalliques ;
les cartes (51, 53) sont munies de zones de connexion (67A, 67B) aptes à coopérer avec les plots, les zones de connexion (67A, 67B) de chaque carte (51, 53) ayant un bord au niveau de la tranche de la carte destinée à être en contact avec le support (57) ; et
au moins une puce de circuit intégré (80) est disposée dans la carte (51, 53) d'au moins un desdits grands côtés, la carte étant configurée pour mettre en œuvre une fonction associée au connecteur et ayant des bornes connectées à des zones de contact et des zones de connexion.

2. Elément de connecteur électrique selon la revendication 1, dans lequel le cadre (47) comprend deux entretoises (55) séparant les grands côtés du cadre.

3. Elément de connecteur électrique selon la revendication 2, dans lequel chaque entretoise (55) est une portion de carte de circuit imprimé.

4. Elément de connecteur électrique selon l'une quelconque des revendications 1 à 3, dans lequel la face externe (63) de chaque carte (51, 53) comprend des premières zones de connexion (67A), la face interne (59) de chaque carte (51, 53) comprend des deuxièmes zones de connexion (67B), chaque première zone de connexion étant en regard d'une deuxième zone de connexion et étant connectée à la deuxième zone de connexion en regard par un premier via traversant (71).

5. Elément de connecteur électrique selon la revendication 4, dans lequel les premiers vias traversants (71) de chaque carte (51, 53) sont ouverts au niveau de la tranche de la carte destinée à être en contact avec le support (57).

6. Elément de connecteur électrique selon l'une quelconque des revendications 1 à 5, dans lequel la face interne (59) de chaque carte (51, 53) comprend des premières zones de contact (61A), la face externe (63) de la carte (51, 53) comprend des deuxièmes zones de contact (61B), chaque première zone de contact étant en regard d'une deuxième zone de contact et étant connectée à la deuxième zone de contact en regard par un deuxième via traversant (65).

7. Elément de connecteur électrique selon l'une quelconque des revendications 1 à 6, dans lequel le cadre (47) est rectangulaire.

8. Elément de connecteur électrique selon l'une quelconque des revendications 1 à 7, dans lequel une plaque (90) ferme le côté du cadre (47) destiné à être en contact avec un support (57).

## Patentansprüche

1. Elektrisches Verbinderelement des Typs, der einen Rahmen (47) aufweist, der einen länglichen offenen Hohlraum (49) begrenzt, der zwei parallele Längsseiten aufweist, die mit Kontaktbereichen (61A, 61B) versehen sind, die mit Kontaktbereichen eines komplementären elektrischen Verbinderelements zusammenwirken können, und der dazu bestimmt ist, auf einem Träger (57) montiert zu werden, der mit leitenden Kontaktflächen (69) versehen ist,
**dadurch gekennzeichnet, dass**:
jede Längsseite aus einer mehrschichtigen gedruckten Leiterplatte (51, 53) gebildet ist, die mindestens drei Ebenen von Metallschichten aufweist;
die Leiterplatten (51, 53) mit Verbindungsbereichen (67A, 67B) versehen sind, die mit den Kontaktflächen zusammenwirken können, wobei die Verbindungsbereiche (67A, 67B) jeder Leiterplatte (51, 53) einen Rand auf der Höhe der Kante der Leiterplatte aufweisen, die mit dem Träger (57) in Kontakt sein soll; und
mindestens ein integrierter Schaltungschip (80) auf der Leiterplatte (51, 53) mindestens einer der Längsseiten angeordnet ist, wobei die Leiterplatte konfiguriert ist zum Implementieren einer mit dem Verbinder assoziierten Funktion, und Anschlüsse aufweist, die mit Verbindungsbereichen und Kontaktbereichen verbunden sind.

2. Elektrisches Verbinderelement nach Anspruch 1, wobei der Rahmen (47) zwei Abstandshalter (55) aufweist, die die Längsseiten von dem Rahmen beabstanden.

3. Elektrisches Verbinderelement nach Anspruch 2, wobei jeder Abstandshalter (55) ein Teil der gedruckten Leiterplatte ist.

4. Elektrisches Verbinderelement nach einem der Ansprüche 1 bis 3, wobei die Außenfläche (63) jeder Leiterplatte (51, 53) erste Verbindungsbereiche (67A) aufweist, die Innenfläche (59) jeder Leiterplatte (51, 53) zweite Verbindungsbereiche (67B) aufweist, wobei jeder erste Verbindungsbereich einem zweiten Verbindungsbereich gegenüberliegt und mit dem gegenüberliegenden zweiten Verbindungsbereich durch eine erste Durchkontaktierung (71) verbunden ist.

5. Elektrisches Verbinderelement nach Anspruch 4, wobei die ersten Durchkontaktierungen (71) jeder Leiterplatte (51, 53) auf der Höhe der Kante der Leiterplatte, die in Kontakt mit dem Träger (57) sein soll, offen sind.

6. Elektrisches Verbinderelement nach einem der Ansprüche 1 bis 5, wobei die Innenfläche (59) jeder Leiterplatte (51, 53) erste Kontaktbereiche (61A) aufweist, wobei die Außenfläche (63) der Leiterplatte (51, 53) zweite Kontaktbereiche (61B) aufweist, wobei jeder erste Kontaktbereich einem zweiten Kontaktbereich gegenüberliegt und mit dem gegenüberliegenden zweiten Kontaktbereich durch eine zweite Durchkontaktierung (65) verbunden ist.

7. Elektrisches Verbinderelement nach einem der Ansprüche 1 bis 6, wobei der Rahmen (47) rechteckig ist.

8. Elektrisches Verbinderelement nach einem der Ansprüche 1 bis 7, wobei eine Platte (90) die Seite des Rahmens (47) verschließt, die in Kontakt mit einem Träger (57) sein soll.

## Claims

1. An electrical connector element of the type comprising a frame (47) delimiting an elongated open cavity (49), having two parallel long sides provided with contact areas (61A, 61B) capable of cooperating with contact areas of a complementary electrical connector element, and being intended to be assembled on a support (57) provided with conductive pads (69),
**characterized in that**:
each long side is formed of a multilayer printed circuit board (51, 53) comprising at least three levels of metal layers;
the boards (51, 53) are provided with connection areas (67A, 67B) capable of cooperating with the pads, the connection areas (67A, 67B) of each board (51, 53) having a rim at the level of the edge of the board intended to be in contact with the support (57); and
at least one integrated circuit chip (80) is arranged in the board (51, 53) of at least one of said long sides, the board being configured to implement a function associated to the connector and having terminals connected to connection areas and contact areas.

2. The electrical connector element of claim 1, wherein the frame (47) comprises two spacers (55) separating the long sides from the frame.

3. The electrical connector element of claim 2, wherein each spacer (55) is a printed circuit board portion.

4. The electrical connector element of any of claims 1 to 3, wherein the external surface (63) of each board (51, 53) comprises first connection areas (67A), the internal surface (59) of each board (51, 53) comprises second connection areas (67B), each first connection area being opposite a second connection area and being connected to the opposite second connection area by a first through via (71).

5. The electrical connector element of claim 4, wherein the first through vias (71) of each board (51, 53) are open at the level of the edge of the board intended to be in contact with the support (57).

6. The electrical connector element of any of claims 1 to 5, wherein the internal surface (59) of each board (51, 53) comprises first contact areas (61A), the external surface (63) of the board (51, 53) comprises second contact areas (61B), each first contact area being opposite a second contact area and being connected to the opposite second contact area by a second through via (65).

7. The electrical connector element of any of claims 1 to 6, wherein the frame (47) is rectangular.

8. The electrical connector element of any of claims 1 to 7, wherein a plate (90) closes the side of the frame (47) intended to be in contact with a support (57).
